# EUROPEAN PATENT SPECIFICATION

(11) **EP 3 627 559 B1**
(45) Date of publication and mention of the grant of the patent: **22.06.2022**
(21) Application number: 18195332.4
(22) Date of filing: 19.09.2018
(51) Int. Cl.: H01L 29/78, H01L 21/336, H01L 29/06, H01L 29/20

(54) **A III-V SEMICONDUCTOR DEVICE AND A METHOD FOR FORMING A III-V SEMICONDUCTOR DEVICE COMPRISING AN EDGE TERMINATION STRUCTURE**
III-V-HALBLEITERBAUELEMENT UND VERFAHREN ZUR HERSTELLUNG EINES III-V-HALBLEITERBAUELEMENTS MIT EINER RANDABSCHLUSSSTRUKTUR
DISPOSITIF SEMICONDUCTEUR III-V ET PROCÉDÉ PERMETTANT DE FORMER UN DISPOSITIF SEMICONDUCTEUR III-V COMPRENANT UNE STRUCTURE DE TERMINAISON DE BORD

(43) Date of publication of application: 25.03.2020
(73) Proprietor: IMEC VZW, 3001 Heverlee (BE); Universiteit Gent, 9000 Gent (BE)
(72) Inventor: BAKEROOT, Benoit, 3001 Leuven (BE)
(74) Representative: AWA Sweden AB

(56) References cited:
- EP-A1- 1 229 591
- US-A1- 2002 063 300
- US-A1- 2006 131 647
- US-A1- 2008 265 314
- US-A1- 2008 308 908
- US-A1- 2009 085 116
- US-A1- 2015 060 942
- US-A1- 2016 013 282
- HEINLE U ET AL: "ANALYSIS OF THE SPECIFIC ON-RESISTANCE OF VERTICAL HIGH-VOLTAGE DMOSFETS ON SOI", IEEE TRANSACTIONS ON ELECTRON DEVICES, IEEE SERVICE CENTER, PISACATAWAY, NJ, US, vol. 50, no. 5, 1 May 2003 (2003-05-01), pages 1416-1419, XP001168195, ISSN: 0018-9383, DOI: 10.1109/TED.2003.813458

## Description

### Technical field

The present inventive concept relates to a method of forming a III-V semiconductor device comprising an edge termination structure. The present inventive concept further relates to a III-V semiconductor device.

### Background

Over the last decades, III-V semiconductor devices have progressively replaced traditional Si-based devices for power applications where a high breakdown voltage is required. For instance, GaN is a promising material for power applications such as vertical channel semiconductor devices. However, the edge termination of such devices typically has a lower breakdown voltage than a parallel-plane structure. This may result into an undesired breakdown of the device edge before the breakdown of the active device part.

US 2008/308908 A1 discloses a nitride semiconductor device and a method for producing nitride semiconductor device. US 2008/265314 A1 discloses a vertical MOSFET. Heinle U. et al., "Analysis of the specific on-resistance of vertical high-voltage DMOSFETs on SOI", IEEE Transactions on Electron devices, IEEE Service Center, Pisacataway, NJ, US, vol. 50, no. 5, May 2003, pages 1416-1419, discloses a vertical high-voltage DMOSFET.

US 2015/060942 A1 discloses a semiconductor device with a group III nitride semiconductor formed over silicon. US 2009/085116 A1 discloses a semiconductor device with a RESURF structure.

### Summary

An objective of the present inventive concept is to provide a III-V semiconductor device suitable for power applications and having an edge termination structure enabling an improved breakdown voltage. Further or alternative objectives may be understood from the following description.

According to a first aspect of the present inventive concept there is in accordance with claim 1 provided a method for forming a III-V semiconductor device comprising:
forming a III-V semiconductor layer stack comprising in a bottom-up direction: a drain contact layer, a drift layer, a channel layer, a body contact layer and a source contact layer, wherein the drain contact layer, the drift layer and the source contact layer have a first conductivity type and the channel layer and the body contact layer have a second conductivity type opposite the first conductivity type,
forming a set of gate structures extending through the source contact layer, the body contact layer and the channel layer,
forming a set of source contacts contacting the source contact layer, and
forming an edge termination structure, wherein forming the edge termination structure comprises:
   forming a drain contact extending through the layer stack and contacting the drain contact layer, and
   forming an insulating region extending vertically through the layer stack, into the channel layer such that a thickness portion of the channel layer remains under a bottom of the insulating region, wherein the remaining thickness portion of the channel layer forms a reduced surface field, RESURF, layer, wherein a length dimension of the insulating region is formed to be greater than a thickness dimension of the drift layer.

According to a second aspect there is in accordance with claim 9 provided a III-V semiconductor device comprising:
a III-V semiconductor layer stack comprising in a bottom-up direction: a drain contact layer, a drift layer, a channel layer, a body contact layer and a source contact layer, wherein the drain contact layer, the drift layer and the source contact layer have a first conductivity type and the channel layer and the body contact layer have a second conductivity type opposite the first conductivity type,
a set of gate structures extending through the source contact layer, the body contact layer and the channel layer,
a set of source contacts contacting the source contact layer, and
an edge termination structure comprising:
   a drain contact extending through the layer stack and contacting the drain contact layer, and
   an insulating region extending vertically through the layer stack, into the channel layer such that a thickness portion of the channel layer remains under a bottom of the insulating region, wherein the remaining thickness portion of the channel layer forms a reduced surface field, RESURF, layer, wherein a length dimension of the insulating region is formed to be greater than a thickness dimension of the drift layer.

The present inventive concept is based on the insight that an increased breakdown voltage may be achieved at an edge termination structure by providing a RESURF layer as part of the layer stack forming the active layers of the III-V semiconductor device.

According to the Reduced Surface Field (RESURF) effect a surface field at an isolation junction is decreased through 2-D depletion. According to the first and second inventive aspects, the RESURF layer enables a reduced peak electrical field at the junction between the first conductivity type drain contact and drift layers and the second conductivity type channel and body contact layers. More specifically, the RESURF layer enables a spreading out of the electrostatic potential along the length of the edge termination structure.

As the RESURF layer is formed by a thickness portion of the channel layer, the channel layer has a double function of supporting one or more vertical channels of the semiconductor device and providing the RESURF layer at the edge termination structure. This also enables the RESURF dose to be conveniently tuned via the doping concentration of the channel layer and the vertical dimension of the insulating region. A thickness and doping level of the channel layer will influence the threshold voltage VT of the device. Accordingly, the doping level of the channel layer can be adjusted to a specific target VT, wherein a thickness of the remaining thickness portion RESURF layer is set to obtain the desired RESURF effect, i.e. to obtain the RESURF dose in the RESURF layer. This may facilitate the device design.

By the configuration of the drain contact layer, drift layer, channel layer, body contact layer and source contact layer in a layer stack, the device structure allows forming of a vertical channel device, more specifically a metal-oxide-semiconductor field-effect-transistor (MOSFET) comprising a set of (one or more) vertically oriented channels. A channel may be defined to extend vertically through the channel layer, along a gate electrode.

By providing a plurality of gate structures and a plurality of source electrodes, a plurality of vertical channels may be formed. Accordingly, the drain contact may be configured as a common drain electrode for the semiconductor device, i.e. common to each of the plural vertical channel devices.

The channel layer may be epitaxially grown on the drift layer and the body contact layer may be epitaxially grown on the channel layer. The channel layer and body contact layer may thus form epitaxial layers. The channel layer and the body contact layer may further be in-situ doped to form layers of the second conductivity type. This allows the channel and body contact layers to be formed with an advantageous degree of control and doped to a respective desired level in a manner reducing the amount of defects and damages, compared to doping by for instance ion implantation.

Advantageously, each one of the layers of the layer stack may be epitaxillay grown and, optionally, in-situ doped to provide the respective first and the second conductivity type.

A doping concentration of the body contact layer may be greater than a doping concentration of the channel layer. Thereby a good electric contact may be achieved between the body contact layer and a body contact. Meanwhile, a lower doping concentration may be provided in the channel layer and thus the RESURF layer. A comparably lower doping concentration in the channel layer enables a desired RESURF does to be obtained at a greater thickness.

The channel layer may comprise GaN. Thereby a GaN-based semiconductor device may be formed. GaN has several properties which makes it advantageous to use in semiconductor device, notably power applications but also in radio frequency and analog applications. Advantageously, each one of the layers of the layer stack may comprise GaN. Each one of the layers of the layer stack may be GaN-layers (i.e. doped or undoped as appropriate).

The first conductivity type may be an n-type and the second conductivity type may be a p-type. Accordingly, the drain contact layer may be an n-type layer, the drift layer may be an n-type layer, the channel layer may be a p-type layer, the body contact layer may be a p-type layer and the source contact layer may be an n-type layer. Thereby, an n-type semiconductor device may be provided, preferably an n-type GaN. Although an n-type semiconductor device may be advantageous for high-voltage operation, it is in principle possible to form a p-type semiconductor device, e.g. a p-type GaN wherein the drain contact layer may be a p-type layer, the drift layer may be a p-type layer, the channel layer may be an n-type layer, the body contact layer may be an n-type layer and the source contact layer may be a p-type layer.

A dopant dose of the RESURF layer falls within a range of 1 E13 at/cm² to 3E13 at/cm². A dopant dose in this range may provide a RESURF effect which contributes appreciably to an improved break down voltage. In other words, a doping concentration of the channel layer and a thickness of the remaining thickness portion below the insulating region should be such that a dopant dose within a range of 1E13 at/cm² to 3E13 at/cm² is obtained in the RESURF layer

A length dimension of the insulating region is formed to be greater than a thickness dimension of the drift layer. This may ensure that breakdown does not occur prematurely.

Forming of the edge termination structure may comprise etching a trench through the layer stack and stopping the etching within the channel layer, thereby forming the trench with said thickness portion of the channel layer remaining under the bottom of the trench. Subsequently, an insulating material may be deposited in the trench. Thus, the RESURF layer may be formed, using reliable and comparably simple processing. The etching may comprise etching (in a top-down direction), through the source contact layer, the body contact layer and into the channel layer until a thickness portion of the channel layer remains under the bottom of the trench. The etching may be stopped at a position such that a desired RESURF dose of the RESURF layer is obtained.

The drain contact may be arranged or formed adjacent to the insulating region of the edge termination structure.

Forming of the drain contact may comprise:
etching a drain contact trench by etching the layer stack in a region adjacent to the insulating region, the drain contact trench extending vertically through the layer stack to expose the drain contact layer, and
forming the drain contact by filling the drain contact trench with a conductive contact material.

The drain contact trench is advantageously formed to extend partially into the drain contact layer, to enable a good electrical connection between the drain contact and the drain contact layer.

The drain contact may be formed either prior to or subsequent to forming the insulating region. If an insulating region comprising a trench is formed prior to the drain contact, the trench may advantageously be filled prior to drain contact trench formation, among others to simplify masking operations.

A drain contact insulating layer may be formed in the drain contact trench prior to filling the drain contact trench with the conductive contact material. Thereafter the drain contact may be formed. An insulating layer may hence be formed between vertical sidewalls of the drain contact and the layers of the layer stack through which the drain contact extends.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is schematic overview of a semiconductor device.
Fig. 2 is an enlarged view of the device of Figure 1.
Figs 3a-3b schematically illustrate a method for forming a semiconductor device

### Detailed description

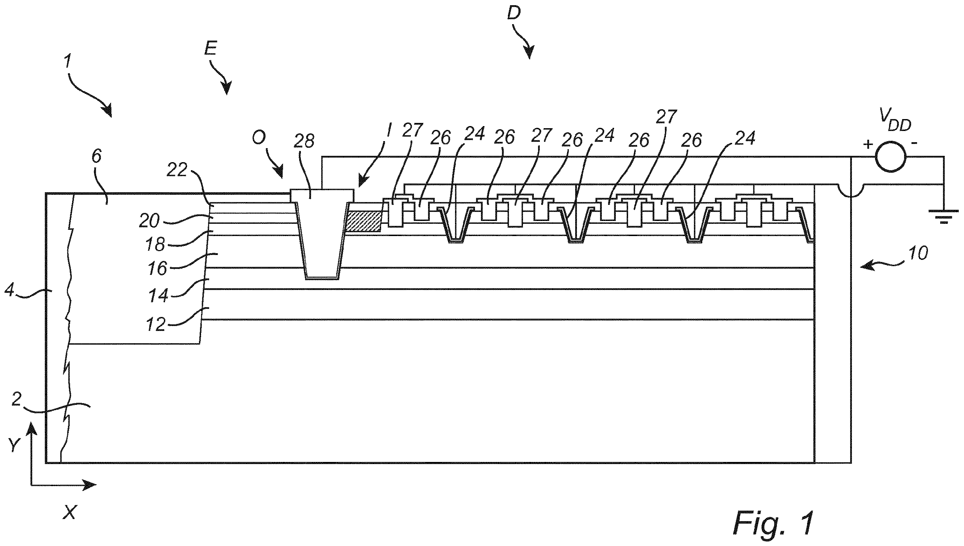

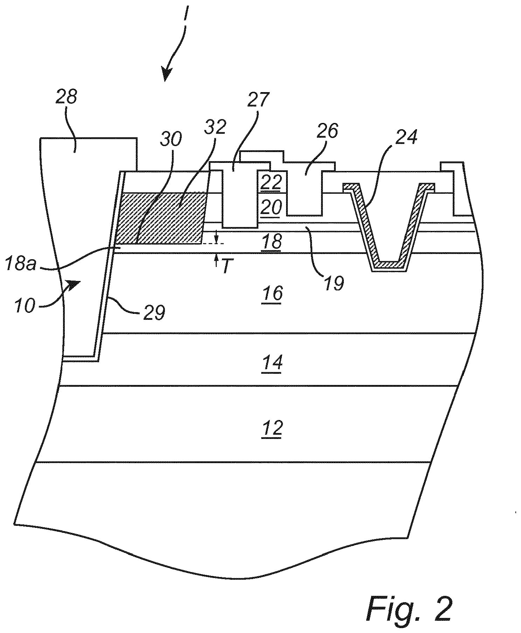

With reference to Figure 1 there is shown, in cross-section, a semiconductor device 1. Figure 2 shows an enlarged view of an inner edge region (denoted "I") of the semiconductor device 1. The structure may extend laterally or horizontally beyond the illustrated section. The illustrated planes of section extending through the structure are common to all the figures unless stated otherwise. It is noted that the relative dimensions of the shown elements, in particular the relative thickness of the layers, is merely schematic and may, for the purpose of illustrational clarity, differ from a physical structure. In Figure 1, directions X and Y indicates a horizontal direction and a vertical direction, respectively.

The device 1 comprises a III-V semiconductor layer stack 10. The layer stack 10 comprises in a bottom-up direction (i.e. being parallel to the vertical direction Y): a drain contact layer 14, a drift layer 16, a channel layer 18, a body contact layer 19 (visible in Figure 2) and a source contact layer 20. The drift layer 16 is formed on the drain contact layer 14. The channel layer 18 is formed on the drift layer 16. The body contact layer 19 is formed on the channel layer 18. The source contact layer 20 is formed on the body contact layer 19. The layer stack 10 may be formed as an epitaxial layer stack wherein each one of the layers of the layer stack 10 may be formed as a respective epitaxial layer. Each one of the layers of the layer stack 10 may be formed by a III-V semiconductor material, for instance GaN or AIGaN. GaN-layers may provide better channel and mobility properties than AIGaN-layers, which may be preferable in some applications. AIGaN-layers on the other hand may provide an even higher critical electrical field than GaN-layers, which may be preferable in some applications. If the layers of the layer stack 10 are formed of AIGaN, the layers may advantageously have the same Al-concentration, to counteract formation of polarization charges.

The drain contact layer 14, the drift layer 16 and the source contact layer 20 may be doped to form layers of an n-type conductivity and the channel layer 18 and the body contact layer 19 may be doped to form layers of a p-type conductivity, or vice versa. According to one example, the drain contact layer 14 may be formed by an n⁺ or n⁺⁺ GaN layer, the drift layer 16 may be formed by an n⁻ GaN layer, the channel layer 18 (and consequently also the thickness portion 18a discussed below) may be formed by a p GaN layer, the body contact layer 19 may be formed by a p⁺ GaN layer and the source contact layer may be formed by an n⁺ or n⁺⁺ GaN layer. By way of example, an n⁺ or n⁺⁺ layer may have a doping concentration in the range of 5E19 to 5E20 cm⁻³ (i.e. 5*10¹⁹ to 5*10²⁰). An n⁻ layer may have a doping concentration in the range of 1E14 to 1E17 cm⁻³. A p or p+ layer may have a doping concentration in the range of 5E16 to 5E18 cm⁻³.

In any case, a first diode junction (i.e. an np- or pn-junction) may be defined (at an interface) between drift layer 16 and the channel layer 18. A second diode junction (i.e. a pn- or np-junction) may be defined (at an interface) between the body contact layer 19 and the source contact layer 20.

The layer stack 10 is formed on a substrate 2. The substrate may be a semiconductor substrate, such as a silicon substrate. As one example, the substrate 2 may be a silicon (Si) substrate having a <111 > upper surface. A Si <111 > surface allows forming the layer stack 10 as a stack of epitaxially grown III-V layers, especially GaN-based layers. A buffer layer structure 12 may be formed on the substrate 2. The drain contact layer 14 may be formed on the buffer layer structure 12. The buffer layer structure 12 may be formed in a manner which per se is known in the art to provide stress relief between the substrate 2 and the layer stack 10.

The device 1 comprises a set of gate structures 24. The section of the device 1 visible in Figure 1 shows three gate structures, and part of a fourth gate structure, commonly referenced 24. However, the device 1 may comprise both a smaller and greater number of gate structures. The set of gate structures 14 may even include only a single gate electrode. Each one of the one or more gate structures 24 of the set of gate structures extends through the source contact layer 20, the body contact layer 19 and the channel layer 18. A vertically oriented MOSFET channel may accordingly be defined in the channel layer 18, along each gate structure 24. The channel may extend between the drift layer 16, through the channel layer 18 and the body contact layer 19, and the source contact layer 20. Since each gate structure 24 extends through the channel layer 18, a vertically oriented channel may be defined on either side of each gate structure 24. Each gate structure 24 may comprise a gate electrode 24e and a gate dielectric 24i. A gate electrode 24e may be formed by a conventional gate material, for instance Ti or TiAl, or as a stack of layers, for instance a stack comprising TiN, Ti, Al. The gate electrode 24e may also comprise a conductive fill material such as W. The gate dielectric 24i may be of a conventional type, such as Al₂O₃, SiO₂ or Si₃N₄, or combinations thereof. Each gate structure 24 may be formed in a respective gate trench formed in the layer stack 10 wherein the gate electrode 24e and the gate dielectric 24i may extend vertically through the channel layer 18. The gate electrode 24e may be laterally coupled (i.e. a capacitive coupling) to the channel layer 18, on either side of the gate structure 24.

The device 1 comprises a set of source contacts 26. The device 1 comprises a set of body contacts 27. As illustrated in Figure 1 the number of source contacts 26 and the number of body contacts 27 may correspond to the number of vertical channels formed along the gate structures 24. Each one of the one or more source contacts 26 is arranged to contact the source contact layer 20. Each one of the one or more body contacts 27 is arranged to contact the body contact layer 19. Each body contact may extend through the source contact layer 20 and into the body contact layer 19. The source contacts 26 and the body contacts 27 may be formed by a conventional contact material, such as Ti and/or Al.

As indicated in Figure 1 and 2 each body contact 27 may be electrically shorted to an adjacent source contact 26. Thus, the source contacts 26/the source contact layer 20 and the body contact 27/the body contact layer 19 may be on the same potential. As further indicated, in Figure 1, by the schematically indicated circuitry connecting the device 1 to VDD and ground, the gate electrodes 24e may be shorted to the body contacts 27. However, these electrical configurations are merely optional and it is generally also possible to form the source and body contacts 26, 27 and gate electrodes 24e as electrically separate contacts.

The device 1 further comprises an edge termination structure comprising a drain contact 28. The drain contact 28 extends vertically through the layer stack 10 and contacts the drain contact layer 14. The drain contact layer 14 extends below each of the gate electrodes 24, and source/body contacts 26/27. Accordingly, the drain contact 28 may form a common drain contact 28 for each of the vertical channels extending through the channel layer 18. The drain contact 28 may be arranged in a drain contact trench extending through the layer stack 10 and to, optionally partly into, the drain contact layer 14. The drain contact 28 may be insulated, laterally, from the layer stack 10 by a drain contact insulating layer 29, arranged along a sidewall of the drain contact 28.

The gate electrodes 24, as well as the source, drain and body contacts 26, 27, 28 may protrude above an insulating layer 22 formed above the layer stack 10, thereby providing electrical access to the contacts. The insulating layer 22 may for instance be formed by a conventional interlayer dielectric (ILD) material, such as an oxide layer. In the figures, the contacts 26, 27, 28 as well as the gate structures 24 are shown to present a tapered shape. This however merely represents an example and it is also possible to form one or more of the contacts 26, 27, 28 and gate structures 24 with vertically oriented/perpendicular sidewalls.

As schematically indicated in Figure 1, the drain contact 28 may be arranged in a peripheral region or edge region "E" of the device 1/substrate 2. The edge region "E" may comprise a saw lane 4, which forms the outermost periphery of the device 1. The edge region "E" may further comprise an outer isolation region 6, laterally separating the layer stack 10 from the saw lane 4. The drain contact 28 has an outer edge "O" facing outwardly towards the outermost periphery. The drain contact 28 has an opposite inner edge "I" facing inwardly towards a central region "D" of the device 1/substrate 2, i.e. away from the outermost periphery. The central region "D" may also be referred to as the active device region "D". The gate structures 24, the source contacts 26 and the body contacts 27 may be formed in the region "D".

The edge termination structure further comprises an insulating region in the form of a trench 30 filled with an insulating material 32, such as a silicon oxide, a combination of materials such as SiO₂/Si₃N₄ or Al₂O₃/SiO₂, or some other dielectric material. As may be more readily appreciated in Figure 2, the trench 30 extends vertically through the layer stack 10, into the channel layer 18 such that a thickness portion 18a of the channel layer 18 remains under a bottom of the trench 30. The remaining thickness portion 18a of the channel layer 18 forms a reduced surface field, RESURF, layer (which also will be referenced 18a). The trench 30 is formed adjacent to the drain contact 28, and extends along the inner edge "I" thereof. A length dimension L of the trench 30 (i.e. along the horizontal direction X) is formed to be greater than a thickness dimension of the drift layer 16. As will be further described below, an insulating region may also be formed through ion implantation into a region of the layer stack 10, the region having an extension corresponding to that of the trench 30.

In any case, the RESURF layer 18a enables a reduced peak electrical field at the junction between the n/p type drain contact and drift layers 14, 16 and the p/n type channel and body contact layers 18, 19. Thus, the breakdown voltage of the main junction adjacent to the edge termination structure may be increased. The RESURF dose (i.e. at/cm2) is determined by the product of the thickness of the RESURF layer 18a and the doping level of the RESURF layer 18a. For instance, for a thickness T and a doping concentration C, the RESURF dose will be T×C. Meanwhile, a thickness and doping level of the channel layer 18 will influence the threshold voltage VT of the device. Accordingly, the doping level of the channel layer 18 can during device design be adjusted to a specific target VT, wherein the thickness T of the remaining thickness portion/RESURF layer 18a may be set to obtain the desired RESURF effect. The doping concentration of the channel layer 18 and the thickness of the remaining thickness portion 18a is set such that a dopant dose of the RESURF layer (i.e. the RESURF dose) may fall within a range of 1E13 at/cm² to 3E13 at/cm². A dopant dose in this range may provide a RESURF effect which contributes appreciably to an improved break down voltage. The RESURF layer may be formed with a thickness in the range of 100-600 nm. A GaN RESURF layer 18a the RESURF dose may advantageously be 1.8E13 at/cm², at least within ±10%, more preferably within ±5%, even more preferably within ±2%.

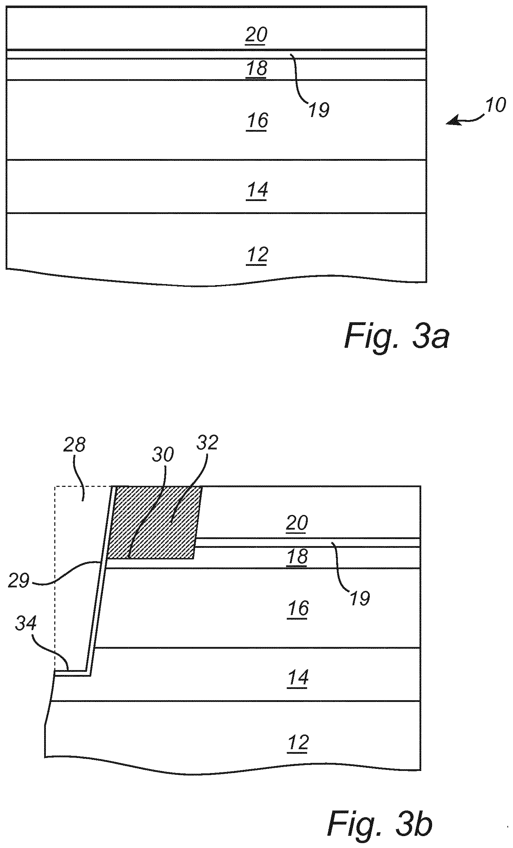

A method for forming the semiconductor device 1 will now be described with reference to Figures 3a-b. Figures 3a-b depict the same region as Figure 2.

In Figure 3a, the III-V semiconductor layer stack 10 has been formed. The drain contact layer 14 may be epitaxially grown on an upper surface of the buffer layer structure 12. The drift layer 16 may be epitaxially grown on an upper surface of the drain contact layer 16. The channel layer 18 may be epitaxially grown on an upper surface of the drift layer 16. The body contact layer 19 may be epitaxially grown on the channel layer 18. The source contact layer 20 may be epitaxially grown on the body contact layer 19. The layers of the layer stack 10 may for instance be formed by metal organic chemical vapor deposition (MOCVD). Each one of the layers may be in-situ doped by introducing suitable impurities (in accordance with the intended conductivity type) in the growth reactor during the epitaxial growth. Doping by ion implantation is also possible, however advantageously at least the channel layer 18 and the body contact layer 19 are in-situ doped to avoid defect formation.

In Figure 3b, the trench 30 of the edge termination structure has been formed and subsequently filled with the insulating material 32. The trench 30 may be formed by etching through the layers of the layer stack 10. The etching may be stopped within the channel layer 18, thereby forming the trench with the thickness portion 18a of thickness T remaining under the bottom of the trench 30. As discussed above in connection with Figures 1 and 2 the remaining thickness portion 18a forms the RESURF layer 18a. The trench formation 30 may comprise forming of an etch mask above the layer stack 10, the etch mask having an opening defining the horizontal dimensions of the trench 30. The trench 30 may thereafter be formed by etching the layer stack 10 through the opening in the etch mask. The etch mask may be of a conventional type, for instance an etch mask comprising a lithographically patterned photoresist layer. Any conventional dry or wet etching processes, suitable for etching III-V semiconductor materials may be used, for instance a dry plasma etching process.

As shown in Figure 3b, the etching of the layer stack 10 may result in formation of a trench 30 with an inclined sidewall. This may however be dependent on the actual etch process used and it may also be possible to obtain a trench 30 with a vertically oriented/perpendicular sidewall.

Subsequent to forming the trench 30 the insulating material 32 may be deposited to fill the trench 30. As mentioned above, the insulating material 32 may for instance be a silicon oxide or some other dielectric material. The insulating material 32 may be deposited using a conventional deposition process, such as chemical vapor deposition (CVD). Insulating material deposited outside of the trench 32 may be removed by for instance etching back the insulating material 32 until an upper surface of the source contact layer 20 is exposed.

According to an alternative approach, an insulating region may be formed through subjecting the layer stack 10 to an ion implantation process. The ion implantation process (for instance implanting N, Ar or He) may be configured to produce an implanted insulating region of damaged crystallographic structure of the layers of the layer stack 10. Similar to the trench 30 and insulating material 32, the damaged region, may extend partly into the channel layer 18 such that an undamaged thickness portion 18a (i.e. the RESURF layer) of the channel layer 18 remains under the insulating region.

Subsequent to the forming of the trench 30 and the insulating layer 32 (or the ion implanted insulating region, as the case may be), the method may proceed with forming of the drain contact 28, as indicated by the dashed lines in Figure 3b. A drain contact trench 34 may be formed adjacent to the trench 30. The drain contact trench 34 may be formed by etching the layer stack 10 in a region adjacent to the trench 30. The drain contact trench may be formed to extend 34 vertically through the layer stack 10 to expose the drain contact layer 14, as shown optionally partly into the drain contact layer 14. The drain contact trench formation may comprise forming of an etch mask above the layer stack 10, the etch mask having an opening defining the horizontal dimensions of the trench 34. The drain contact trench 34 may thereafter be formed by etching the layer stack 10 through the opening in the etch mask. The etch mask may be of a conventional type, for instance an etch mask comprising a lithographically patterned photoresist layer. For instance, a same etching process as used during the formation of the trench 30 may be used.

Subsequent to forming the drain contact trench 34, the drain contact 28 may be formed by filling the drain contact trench 34 with a conductive contact material. A drain contact insulating layer 29 may be deposited in the drain contact trench 34 prior to depositing the conductive contact material. The drain contact insulating layer 29 may be formed by depositing a conformal insulating layer using atomic layer deposition (ALD), for instance an ALD oxide or a low-k ALD dielectric. The conformal layer may subsequently be etched such that a conformal insulating layer remains only on the sidewall of the drain contact trench 29. Alternatively, an oxide or other low-k dielectric may be deposited by CVD and subsequently etched such that an insulating layer 29 remains only on the sidewall of the drain contact trench 34.

The set of gate structures 24, the set of source contacts 26 and the set drain contacts 27 may be formed in a corresponding manner to arrive at the device 1 shown in Figures 1 and 2. Respective trenches for the sets of contacts 26, 27 and the set of gate structures 24 may be formed in the layer stack 10. The set of source contact trenches may be etched to expose the source contact layer 20. The set of body contact trenches may be etched to expose the body contact layer 19. The contact trenches may subsequently be filled with a conductive contact material, possibly preceded by a forming of an insulating layer on sidewalls of the contact trenches. The etching of the contact trenches for the drain contact 28, the set of source contacts 26 and the set of body contacts 27 may be formed in sequential patterning processes. Conductive contact material may thereafter be deposited to form a conductive material layer covering the layer stack 10 and filling the contact trenches holes. The conductive material layer may subsequently be patterned to form the drain contact 28, the source contacts 26 and the body contacts 27. It is however also possible to form the contacts 26, 27 and 28 sequentially, in separate etching and deposition processes.

Respective gate trenches for the set of gate structures 24 may be formed in the layer stack 10, advantageously prior to forming the contacts 26, 27, 28. The set of gate trenches may be etched to extend through the channel layer 18, and optionally partly into the drift layer 16. The gate structures 24 may thereafter be formed by first depositing the gate dielectric layer 24i and thereafter depositing conductive gate material for the gate electrodes 24e.

The layer stack 10 may be covered by the insulating layer 22 prior to forming the set of gate structures 24, the set of source contacts 26 and the set drain contacts 27, and optionally also prior to forming the trench 30. In that case the respective trenches may comprise etching through also the insulating layer 22. Alternatively, the insulating layer 22 may be formed after trench and gate/contact formation. Electrical access to the gates and contacts may then be provided by etching openings in the insulating layer 22 above the gate structures 24 and source and body contacts 26, 27 forming vertical via connections therein.

In the above the formation and filling of the trench 30 occurs prior to forming the drain contact trench 34. However, it is also possible to form the drain contact trench 34, the drain contact insulating layer 29 and the drain contact 28 prior to forming the trench 30. Moreover, the gate structures 24, the set of source contacts 26 and the set of body contacts 27 may be formed in any mutual order, and either before or after forming and filling the trench 30.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method forming a III-V semiconductor device (1) comprising:
forming a III-V semiconductor layer stack (10) comprising in a bottom-up direction: a drain contact layer (14), a drift layer (16), a channel layer (18), a body contact layer (19) and a source contact layer (20), wherein the drain contact layer (14), the drift layer (16) and the source contact layer (20) have a first conductivity type and the channel layer (18) and the body contact layer (19) have a second conductivity type opposite the first conductivity type,
forming a set of gate structures (24) extending through the source contact layer (20), the body contact layer (19) and the channel layer (18),
forming a set of source contacts (26) contacting the source contact layer (20), and
forming an edge termination structure, wherein forming the edge termination structure comprises:
forming a drain contact (28) extending through the layer stack (10) and contacting the drain contact layer (14), and
forming an insulating region (30, 32) extending vertically through the layer stack (10), into the channel layer (18) such that a thickness portion (18a) of the channel layer (18) remains under a bottom of the insulating region (30, 32), wherein the remaining thickness portion (18a) of the channel layer forms a reduced surface field, RESURF, layer, wherein a length dimension of the insulating region (30, 32) is formed to be greater than a thickness dimension of the drift layer (16).

2. A method according to any claim 1, wherein the channel layer (18) is epitaxially grown on the drift layer (16) and the body contact layer (19) is epitaxially grown on the channel layer (18), and wherein the channel layer (18) and the body contact layer (19) are in-situ doped to form layers of the second conductivity type.

3. A method according to any preceding claim, wherein a doping concentration of the body contact layer (19) is greater than a doping concentration of the channel layer (18).

4. A method according to any preceding claim, wherein the channel layer (18) comprises GaN.

5. A method according to any preceding claim, wherein a dopant dose of the RESURF layer falls within a range of 1E13 at/cm² to 3E13 at/cm².

6. A method according to any preceding claim, wherein forming the edge termination structure comprises etching a trench (30) through the layer stack (10) and stopping the etching within the channel layer (18), and depositing an insulating material (32) in the trench (30).

7. A method according to any preceding claim, further comprising:
etching a drain contact trench (34) by etching the layer stack (10) in a region adjacent to the insulating region (30, 32), the drain contact trench extending (34) vertically through the layer stack (10) to expose the drain contact layer (14), and
forming the drain contact (28) by filling the drain contact trench (34) with a conductive contact material.

8. A method according to claim 7, further comprising forming a drain contact insulating layer (29) in the drain contact trench (34) and thereafter forming the drain contact (28).

9. A III-V semiconductor device (1) comprising:
a III-V semiconductor layer stack (10) comprising in a bottom-up direction: a drift layer (16), a channel layer (18), and a source contact layer (20), wherein the drift layer (16) and the source contact layer (20) have a first conductivity type and the channel layer (18) has a second conductivity type opposite the first conductivity type,
a set of gate structures (24) extending through the source contact layer (20) and the channel layer (18), and
a set of source contacts (26) contacting the source contact layer (20), and **characterized by**:
the III-V semiconductor layer stack (10) further comprising a drain contact layer (14) and a body contact layer (19), wherein the III-V semiconductor layer stack (10) comprises in the bottom-up direction: the drain contact layer (14), the drift layer (16), the channel layer (18), the body contact layer (19) and the source contact layer (20), wherein the drain contact layer (14) has the first conductivity type, and the body contact layer (19) has the second conductivity type, and wherein the set of gate structures (24) extend through the body contact layer (19), the device (10) further comprising:
an edge termination structure comprising:
a drain contact (28) extending through the layer stack (10) and contacting the drain contact layer (14), and
an insulating region (30, 32) extending vertically through the layer stack (10), into the channel layer (18) such that a thickness portion (18a) of the channel layer (18) remains under a bottom of the insulating region (30, 32), wherein the remaining thickness portion (18a) of the channel layer forms a reduced surface field, RESURF, layer, wherein a length dimension of the insulating region (30, 32) is formed to be greater than a thickness dimension of the drift layer (16).

10. A III-V semiconductor device according to any claim 9, wherein the channel layer (18) is an epitaxial layer arranged on the drift layer (16) and the body contact layer (19) an epitaxial layer is arranged on the channel layer (18).

11. A III-V semiconductor device according to any of claims 9-10, wherein a doping concentration of the body contact layer (19) is greater than a doping concentration of the channel layer (18).

12. A III-V semiconductor device according to any of claims 9-11, wherein the channel layer (18) comprises GaN.

13. A III-V semiconductor device according to claim 12, wherein a dopant dose of the RESURF layer falls within a range of 1E13 at/cm² to 3E13 at/cm².

## Patentansprüche

1. Verfahren zum Bilden eines III-V-Halbleiterbauelements (1), umfassend folgende Schritte:
Bilden eines III-V-Halbleiterschichtstapels (10), der in einer Richtung von unten nach oben umfasst: eine Drain-Kontaktschicht (14), eine Drift-Schicht (16), eine Kanalschicht (18), eine Körperkontaktschicht (19) und eine Source-Kontaktschicht (20), wobei die Drain-Kontaktschicht (14), die Drift-Schicht (16) und die Source-Kontaktschicht (20) einen ersten Leitfähigkeitstyp aufweisen, und die Kanalschicht (18) und die Körperkontaktschicht (19) einen zweiten Leitfähigkeitstyp, der dem ersten Leitfähigkeitstyp entgegengesetzt ist, aufweisen,
Bilden eines Satzes von Gate-Strukturen (24), die sich durch die Source-Kontaktschicht (20), die Körperkontaktschicht (19) und die Kanalschicht (18) hindurch erstrecken,
Bilden eines Satzes von Source-Kontakten (26), welche die Source-Kontaktschicht (20) kontaktieren, und
Bilden einer Randabschlussstruktur, wobei das Bilden der Randabschlussstruktur umfasst:
Bilden eines Drain-Kontaktes (28), der sich durch den Schichtstapel (10) hindurch erstreckt und die Drain-Kontaktschicht (14) kontaktiert, und
Bilden einer Isolierregion (30, 32), die sich senkrecht durch den Schichtstapel (10) hindurch in die Kanalschicht (18) erstreckt, so dass ein Dickenabschnitt (18a) der Kanalschicht (18) unter einer Unterseite der Isolierregion (30, 32) zurückbleibt, wobei der zurückbleibende Dickenabschnitt (18a) der Kanalschicht eine Schicht mit reduziertem Oberflächenfeld, RESURF, bildet, wobei eine Längendimension der Isolierregion (30, 32) gebildet ist, um größer als eine Dickendimension der Drift-Schicht (16) zu sein.

2. Verfahren nach Anspruch 1, wobei die Kanalschicht (18) auf der Drift-Schicht (16) epitaktisch gezogen wird, und die Körperkontaktschicht (19) auf der Kanalschicht (18) epitaktisch gezogen wird, und wobei die Kanalschicht (18) und die Körperkontaktschicht (19) in situ dotiert werden, um Schichten mit dem zweiten Leitfähigkeitstyp zu bilden.

3. Verfahren nach einem der vorhergehenden Ansprüche, wobei eine Dotierungskonzentration der Körperkontaktschicht (19) größer als eine Dotierungskonzentration der Kanalschicht (18) ist.

4. Verfahren nach einem der vorhergehenden Ansprüche, wobei die Kanalschicht (18) GaN umfasst.

5. Verfahren nach einem der vorhergehenden Ansprüche, wobei eine Dotierstoffdosis der RESURF-Schicht in einem Bereich von 1E13 at/cm² bis 3E13 at/cm² liegt.

6. Verfahren nach einem der vorhergehenden Ansprüche, wobei das Bilden der Randabschlussstruktur das Ätzen eines Grabens (30) durch den Schichtstapel (10) hindurch und das Anhalten des Ätzens in der Kanalschicht (18) und das Abscheiden eines Isoliermaterials (32) in dem Graben (30) umfasst.

7. Verfahren nach einem der vorhergehenden Ansprüche, ferner umfassend:
Ätzen eines Drain-Kontaktgrabens (34) durch Ätzen des Schichtstapels (10) in einer Region neben der Isolierregion (30, 32), wobei sich der Drain-Kontaktgraben (34) senkrecht durch den Schichtstapel (10) hindurch erstreckt, um die Drain-Kontaktschicht (14) freizulegen, und
Bilden des Drain-Kontakts (28) durch Ausfüllen des Drain-Kontaktgrabens (34) mit einem leitfähigen Kontaktmaterial.

8. Verfahren nach Anspruch 7, ferner umfassend das Bilden einer Drain-Kontaktisolierschicht (29) in dem Drain-Kontaktgraben (34) und anschließend das Bilden des Drain-Kontaktes (28).

9. III-V-Halbleiterbauelement (1), umfassend:
einen III-V-Halbleiterschichtstapel (10), der in einer Richtung von unten nach oben umfasst: eine Drift-Schicht (16), eine Kanalschicht (18) und eine Source-Kontaktschicht (20), wobei die Drift-Schicht (16) und die Source-Kontaktschicht (20) einen ersten Leitfähigkeitstyp aufweisen, und die Kanalschicht (18) einen zweiten Leitfähigkeitstyp, der dem ersten Leitfähigkeitstyp entgegengesetzt ist, aufweist,
einen Satz von Gate-Strukturen (24), die sich durch die Source-Kontaktschicht (20) und die Kanalschicht (18) hindurch erstrecken, und
einen Satz von Source-Kontakten (26), welche die Source-Kontaktschicht (20) kontaktieren, und
**dadurch gekennzeichnet, dass**:
der III-V-Halbleiterschichtstapel (10) ferner eine Drain-Kontaktschicht (14) und eine Körperkontaktschicht (19) umfasst, wobei der III-V-Halbleiterschichtstapel (10) in der Richtung von unten nach oben umfasst: die Drain-Kontaktschicht (14), die Drift-Schicht (16), die Kanalschicht (18), die Körperkontaktschicht (19) und die Source-Kontaktschicht (20), wobei die Drain-Kontaktschicht (14) den ersten Leitfähigkeitstyp aufweist, und die Körperkontaktschicht (19) den zweiten Leitfähigkeitstyp aufweist, und wobei sich der Satz von Gate-Strukturen (24) durch die Körperkontaktschicht (19) hindurch erstreckt, wobei das Bauelement (10) ferner umfasst:
eine Randabschlussstruktur, umfassend:
einen Drain-Kontakt (28), der sich durch den Schichtstapel (10) hindurch erstreckt und die Drain-Kontaktschicht (14) kontaktiert, und
eine Isolierregion (30, 32), die sich senkrecht durch den Schichtstapel (10) hindurch in die Kanalschicht (18) erstreckt, so dass ein Dickenabschnitt (18a) der Kanalschicht (18) unter einer Unterseite der Isolierregion (30, 32) zurückbleibt, wobei der zurückbleibende Dickenabschnitt (18a) der Kanalschicht eine Schicht mit reduziertem Oberflächenfeld, RESURF, bildet, wobei eine Längendimension der Isolierregion (30, 32) gebildet ist, um größer als eine Dickendimension der Drift-Schicht (16) zu sein.

10. III-V-Halbleiterbauelement nach Anspruch 9, wobei die Kanalschicht (18) eine epitaktische Schicht ist, die auf der Drift-Schicht (16) angeordnet ist, und die Körperkontaktschicht (19) eine epitaktische Schicht ist, die auf der Kanalschicht (18) angeordnet ist.

11. III-V-Halbleiterbauelement nach einem der Ansprüche 9 bis 10, wobei eine Dotierungskonzentration der Körperkontaktschicht (19) größer als eine Dotierungskonzentration der Kanalschicht (18) ist.

12. III-V-Halbleiterbauelement nach einem der Ansprüche 9 bis 11, wobei die Kanalschicht (18) GaN umfasst.

13. III-V-Halbleiterbauelement nach Anspruch 12, wobei eine Dotierstoffdosis der RESURF-Schicht in einem Bereich von 1E13 at/cm² bis 3E13 at/cm² liegt.

## Revendications

1. Procédé de formation d'un dispositif semi-conducteur III-V (1) comprenant :
la formation d'une pile de couches semi-conductrices III-V (10) comprenant, dans une direction du bas vers le haut : une couche de contact de drain (14), une couche de dérive (16), une couche de canal (18), une couche de contact de corps (19) et une couche de contact de source (20), dans lequel la couche de contact de drain (14), la couche de dérive (16) et la couche de contact de source (20) ont un premier type de conductivité et la couche de canal (18) et la couche de contact de corps (19) ont un deuxième type de conductivité opposé au premier type de conductivité,
la formation d'un ensemble de structures de grille (24) s'étendant à travers la couche de contact de source (20), la couche de contact de corps (19) et la couche de canal (18),
la formation d'un ensemble de contacts de source (26) contactant la couche de contact de source (20), et
la formation d'une structure de terminaison de bord, dans lequel la formation de la structure de terminaison de bord comprend :
la formation d'un contact de drain (28) s'étendant à travers la pile de couches (10) et contactant la couche de contact de drain (14), et
la formation d'une zone isolante (30, 32) s'étendant verticalement à travers la pile de couches (10) dans la couche de canal (18) de manière à ce qu'une partie d'épaisseur (18a) de la couche de canal (18) subsiste sous une partie inférieure de la zone isolante (30, 32), dans lequel la partie d'épaisseur résiduelle (18a) de la couche de canal forme une couche à champ de surface réduit, RESURF, dans lequel une dimension en longueur de la région isolante (30, 32) est formée de manière à être supérieure à une dimension en épaisseur de la couche de dérive (16).

2. Procédé selon la revendication 1, dans lequel on fait croître de manière épitaxiale la couche de canal (18) sur la couche de dévie (16) et fait croître de manière épitaxiale la couche de contact de corps (19) sur la couche de canal (18), et dans lequel la couche de canal (18) et la couche de contact de corps (19) sont dopées in-situ pour former des couches du deuxième type de conductivité.

3. Procédé selon l'une quelconque des revendications précédentes, dans lequel une concentration de dopage de la couche de contact de corps (19) est supérieure à une concentration de dopage de la couche de canal (18).

4. Procédé selon l'une quelconque des revendications précédentes, dans lequel la couche de canal (18) comprend du GaN.

5. Procédé selon l'une quelconque des revendications précédentes, dans lequel une dose de dopant de la couche RESURF se situe dans les limites d'une plage comprise entre 1E13 at/cm² et 3E13 at/cm²

6. Procédé selon l'une quelconque des revendications précédentes, dans lequel la formation de la structure de terminaison de bord comprend la gravure d'une tranchée (30) à travers la pile de couches (10) et l'arrêt de la gravure à l'intérieur de la couche de canal (18), et le dépôt d'un matériau isolant (32) dans la tranchée (30).

7. Procédé selon l'une quelconque des revendications précédentes, comprenant en outre :
la gravure d'une tranchée de contact de drain (34) par gravure de la pile de couches (10) dans une zone adjacente à la zone isolante (30, 32), la tranchée de contact de drain (34) s'étendant verticalement à travers la pile de couches (10) pour exposer la couche de contact de drain (14), et
la formation du contact de drain (28) par remplissage de la tranchée de contact de drain (34) avec un matériau de contact conducteur.

8. Procédé selon la revendication 7, comprenant en outre la formation d'une couche isolante de contact de drain (29) dans la tranchée de contact de drain (34) et ensuite la formation du contact de drain (28).

9. Dispositif semi-conducteur III-V (1) comprenant :
une pile de couches semi-conductrices III-V (10) comprenant, dans une direction du bas vers le haut : une couche de dérive (16), une couche de canal (18), et une couche de contact de source (20), dans lequel la couche de dérive (16) et la couche de contact de source (20) ont un premier type de conductivité et la couche de canal (18) a un deuxième type de conductivité opposé au premier type de conductivité,
un ensemble de structures de grille (24) s'étendant à travers la couche de contact de source (20) et la couche de canal (18), et
un ensemble de contacts de source (26) contactant la couche de contact de source (20), et **caractérisé en ce que** :
la pile de couches semi-conductrices III-V (10) comprend en outre une couche de contact de drain (14) et une couche de contact de corps (19), dans lequel la pile de couches semi-conductrices III-V (10) comprend, dans la direction du bas vers le haut : la couche de contact de drain (14), la couche de dérive (16), la couche de canal (18), la couche de contact de corps (19) et la couche de contact de source (20), dans lequel la couche de contact de drain (14) a le premier type de conductivité et la couche de contact de corps (19) a le deuxième type de conductivité, et dans lequel l'ensemble de structures de grille (24) s'étend à travers la couche de contact de corps (19), le dispositif (10) comprenant en outre :
une structure de terminaison de bord comprenant :
un contact de drain (28) s'étendant à travers la pile de couches (10) et contactant la couche de contact de drain (14), et
une zone isolante (30, 32) s'étendant verticalement à travers la pile de couches (10) à l'intérieur de la couche de canal (18) de telle sorte qu'une partie d'épaisseur (18a) de la couche de canal (18) subsiste sous une partie inférieure de la zone isolante (30, 32), dans lequel la partie d'épaisseur (18a) résiduelle de la couche de canal forme une couche à champ de surface réduit, RESURF, dans lequel une dimension en longueur de la zone isolante (30, 32) est formée de manière à être supérieure à une dimension en épaisseur de la couche de dérive (16).

10. Dispositif semi-conducteur III-V selon la revendication 9, dans lequel la couche de canal (18) est une couche épitaxiale disposée sur la couche de dérive (16), et la couche de contact de corps (19) est une couche épitaxiale disposée sur la couche de canal (18).

11. Dispositif semi-conducteur III-V selon l'une quelconque des revendications 9-10, dans lequel une concentration de dopage de la couche de contact de corps (19) est supérieure à une concentration de dopage de la couche de canal (18).

12. Dispositif semi-conducteur III-V selon l'une quelconque des revendications 9-11, dans lequel la couche de canal (18) comprend du GaN.

13. Dispositif semi-conducteur III-V selon la revendication 12, dans lequel une dose de dopant de la couche RESURF se situe dans les limites d'une plage comprise entre 1E13 at/cm² et 3E13 at/cm²
